# EUROPÄISCHE PATENTANMELDUNG

(11) **EP 0 964 404 A2**
(43) Veröffentlichungstag der Anmeldung: **15.12.1999**
(21) Anmeldenummer: 99109934.2
(22) Anmeldetag: 20.05.1999
(51) Int. Cl.: G11C 7/00, G11C 11/409

(54) **Halbleiterspeicher mit differentiellen Bitleitungen**

(30) Priorität: 20.05.1998 DE 19822750
(71) Anmelder: SIEMENS AKTIENGESELLSCHAFT, 80333 München (DE); Marx, Thilo, 80997 München (DE)
(72) Erfinder: Markert, Michael, 86152 Augsburg (DE); Saglam, Musa, 81549 München (DE); Schöniger, Sabine, 81737 München (DE); Schrogmeier, Peter, 81547 München (DE); Dietrich, Stefan, Dr., 82299 Türkenfeld (DE); Hein, Thomas, 81541 München (DE); Marx, Thilo, 80997 München (DE)

(57) **Zusammenfassung**

Bei einem Halbleiterspeicher sind die Bitleitungen (Bl0, bBL0, bBL1, BL1, BL2, bBL2) derart angeordnet, daß jeweils zwei invertierte und zwei nichtinvertierte Bitleitungen (bBL0, bBL1; BL1, BL2) nebeneinander liegen. Benachbarte Schalttransistoren (8, 9) zum Anschluß der Bitleitungen (bBL0, bBL1) an eine invertierte oder eine nichtinvertierte Sammelleitung (bLDQ, LDQ), werden daher mit einem gemeinsamen Kontakt (13; 132) an die entsprechende Sammelleitung (bLDQ) angeschlossen. Ein weiterer Flächenvorteil ergibt sich dadurch, daß beide Schalttransistoren (8, 9) ein gemeinsames Dotierungsgebiet (131) aufweisen.

## Beschreibung

Die Erfindung betrifft einen Halbleiterspeicher mit invertierten und nichtinvertierten Bitleitungen sowie entsprechenden Sammelleitungen und diese verbindende Schalttransistoren.

Wie in der US 4 875 192 beschrieben enthält ein Halbleiterspeicher eine regelmäßige, matrixartige Anordnung von Speicherzellen zur Speicherung binärer Daten. Eine Speicherzelle umfaßt im wesentlichen einen Zugangstransistor und einen Speicherkondensator und speichert ein Informationsbit. Eine Vielzahl von Speicherzellen ist an eine Bitleitung angeschlossen. Über die Bitleitung wird die in die Speicherzelle einzuschreibende und aus ihr auszulesende Information bereitgestellt. Über eine Wortleitung wird die gewünschte Speicherzelle ausgewählt. Ein Leseverstärker verstärkt während des Auslesevorgangs das aus der Speicherzelle ausgelesene Signal. Über einen Schalttransistor wird nach dem Verstärkungsvorgang die Bitleitung mit einer Sammelleitung verbunden, welche an den Ausgang des Halbleiterspeichers führt.

Der Leseverstärker ist als Differenzverstärker ausgeführt. An den differentiellen Eingängen des Differenzverstärkers ist je eine Bitleitung angeschlossen. In einer Speicherzelle wird entweder das zu speichernde Informationsbit selbst oder dessen invertierter Datenwert gespeichert wird, was davon abhängt, an welchen Eingang des Differenzverstärkers die der Speicherzelle zugeordnete Bitleitung angeschlossen ist. An eine Bitleitung sind entweder nur Speicherzellen, in denen die Dateninformation nicht invertiert gespeichert wird, oder nur Speicherzellen, in denen die Dateninformation invertiert gespeichert wird. Die entsprechenden Bitleitungen werden daher als nichtinvertierte oder invertierte Bitleitungen bezeichnet. In der US 4 875 192 gezeigten Anordnung sind invertierte und nichtinvertierte Bitleitungen abwechselnd nebeneinander angeordnet.

In der US 5 280 443 ist ein Halbleiterspeicher beschrieben, bei dem die Bitleitungen über Kreuz geführt werden, um unsymmetrische kapazitive Belastungen der Bitleitungen beim Speicherzugriff zu vermeiden. Am leseverstärkerseitigen Ende der Bitleitungen liegen jeweils zwei invertierte und zwei nichtinvertierte Bitleitungen nebeneinander. Über Schalttransistoren sind die Bitleitungen auf eine invertierte oder nichtinvertierte Sammelleitung schaltbar. Dabei können invertierte und nichtinvertierte Bitleitungen an die gleiche Sammelleitung geschaltet werden.

Die Aufgabe der Erfindung besteht darin, einen Halbleiterspeicher anzugeben, der mit geringerem Verbrauch an Siliziumfläche realisiert werden kann.

Erfindungsgemäß wird diese Aufgabe durch einen Halbleiterspeicher gemäß den Merkmalen des Patentanspruchs 1 gelöst.

Beim Halbleiterspeicher gemäß der Erfindung sind je zwei invertierte und je zwei nichtinvertierte Bitleitungen unmittelbar nebeneinander angeordnet, d.h. ohne eine weitere dazwischen liegende Bitleitung. Im Vergleich zu bisherigen Speicherarchitekturen ist die Reihenfolge der Bitleitungen im Hinblick auf deren Zuordnung zur Speicherung von invertierter oder nichtinvertierter Information geändert. Dies hat zur Folge, daß je zwei Kontakte zum Anschluß der Bitleitungen an dieselbe Sammelleitung räumlich nebeneinander liegen. Zweckmäßigerweise werden diese Kontakte zu einem einzigen zusammengefaßt. Außerdem ist vorteilhaft, die Dotierungsgebiete der Schalttransistoren, die die Bitleitungen an die Sammelleitung durchschalten, zu einem einzigen Dotierungsgebiet zusammenzufassen. Dadurch ergibt sich ein Flächengewinn. Die Dotierungsgebiete der entsprechenden Schalttransistoren zum Anschluß an die Sammelleitungen sind demgegenüber in der US 4 875 192 abwechselnd an die invertierte oder die nichtinvertierte Sammelleitung zu kontaktieren. Vorteilhafterweise weisen die Gateelektroden der Schalttransistoren einen geknickten Verlauf auf. Der Flächengewinn in Richtung der Sammelleitung wird dadurch unter Beibehaltung der wirksamen Transistorgeometrie umgesetzt in einen dazu senkrecht, in Richtung der Bitleitungen wirkenden Flächengewinn. Die gesamte belegte Fläche des Halbleiterchips ist dadurch verringert.

Nachfolgend wird die Erfindung anhand der in der Zeichnung dargestellten Figuren näher erläutert. Es zeigen
- Figur 1: ein Prinzipschaltbild eines Halbleiterspeichers,
- Figur 2: eine Aufsicht auf das Layout zweier Schalttransistoren, die Bitleitungen mit einer Sammeldatenleitung verbinden, und
- Figur 3: eine Aufsicht auf ein entsprechendes Layout mit geknicktem Verlauf der Gateelektroden.

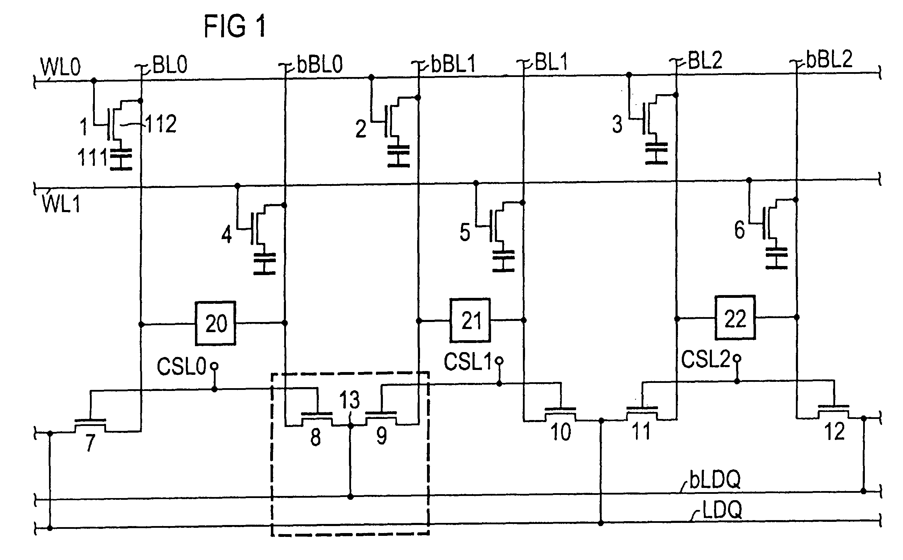

In der Figur 1 ist ein Ausschnitt aus dem Speicherzellenfeld eines Halbleiterspeichers mit Speicherzellen 1, ..., 6 gezeigt. Jede Speicherzelle umfaßt einen Speicherkondensator 111, der am einem Anschluß mit Bezugspotential, z.B. Masse, verbunden ist und am anderen Anschluß mit dem Drain-Source-Pfad eines MOS-Transistors 112. Der andere Anschluß des MOS-Transistors 112 ist mit der Bitleitung BL0 verbunden. Zum Einlesen und Auslesen der im Kondensator 111 zu speichernden bzw. gespeicherten Dateninformation wird durch ein entsprechendes Steuersignal auf der Wortleitung WL0 der Transistor 112 leitend geschaltet, so daß der Kondensator 111 mit der Bitleitung BL0 leitend verbunden wird. Die anderen Speicherzellen 2, ..., 6 sind entsprechend ausgeführt. Unmittelbar neben der Bitleitung BL0 ist die Bitleitung bBL0 angeordnet. Mit der Bitleitung bBL0 ist die Speicherzelle 4 verbunden, deren Auswahltransistor über eine andere Wortleitung WL1 ansteuerbar ist.

Beide Bitleitungen BL0, bBL0 sind eingangs- und ausgangsseitig mit einem Leseverstärker 20 verbunden. Beim Auslesen von Dateninformation aus den Speicherzellen 1 oder 4 wird das entsprechende Signal aus dem Speicherkondensator an die jeweilige Bitleitung BL0 bzw. bBL0 gelegt und durch den Leseverstärker 20 verstärkt. Der Leseverstärker 20 ist als Differenzverstärker ausgeführt. In der Speicherzelle 1 ist das gespeicherte Informationsbit nicht invertiert gespeichert, da die Bitleitung BL0 mit dem nicht invertierend verstärkenden Eingang des Leseverstärkers 20 verbunden ist. Das in der Speicherzelle 4 gespeicherte Informationsbit ist invertiert gespeichert, da die Bitleitung bBL0 mit dem invertiert verstärkenden Eingang des Leseverstärkers 20 verbunden ist. Die Speicherzelle 2 ist an die invertierte Bitleitung bBL1 angeschlossen, die Speicherzelle 5 an die nichtinvertierte Bitleitung BL1. Beide Bitleitungen BL1, bBL1 sind mit dem Leseverstärker 21 eingangsseitig verbunden. In Fortsetzung dieses Prinzips ist die Speicherzelle 3 mit der nichtinvertierten Bitleitung BL2 verbunden, die Speicherzelle 6 mit der invertierten Bitleitung bBL2. Letztere Bitleitungen sind mit dem Leseverstärker 22 eingangsseitig verbunden. Die Speicherzellen 2, 3 werden von der Wortleitung WL0 ausgewählt, die Speicherzellen 4, 5, 6 von der anderen Wortleitung WL1. Die Bitleitungen verlaufen parallel zueinander. In Betrachtungsrichtung senkrecht zum Verlauf der Bitleitungen folgt auf eine erste invertierte Bitleitung eine zweite invertierte Bitleitung, z.B. bBL0, bBL1; auf eine zweite invertierte Bitleitung folgt eine erste nichtinvertierte Bitleitung, z.B. bBL1, BL1; auf eine erste nichtinvertierte Bitleitung folgt eine zweite nichtinvertierte Bitleitung, z.B. BL1, BL2; anschließend folgt wiederum eine erste invertierte Bitleitung, z.B. bBL2, und die Folge von nichtinvertierten und invertierten Bitleitungen wiederholt sich. Es liegen daher stets genau zwei invertierte und zwei nichtinvertierte Bitleitungen in Betrachtungsrichtung senkrecht zum Verlauf der Bitleitungen unmittelbar nebeneinander vor, d.h. ohne dazwischen liegende weitere Bitleitungen.

Nach dem Verstärkungsvorgang beim Auslesen werden die an den Bitleitungen anliegenden Daten auf zwei Sammelleitungen LDQ, bLDQ ausgegeben. Die nichtinvertierte Sammelleitung LDQ empfängt die Signale der nichtinvertierten Bitleitungen BL0, BL1, BL2. In entsprechender Weise leitet die invertierte Sammeleitung bLDQ die ausgelesene Dateninformation der invertierten Bitleitungen bBL0, bBL1, bBL2 weiter. Die Bitleitungen sind über entsprechende Schalttransistoren 7, ..., 12 mit den jeweils zugeordneten Sammelleitungen verbunden. Über die Sammelleitungen wird das ausgelesene Datenbit in Richtung des Ausgangs des integrierten Halbleiterspeichers weiter geleitet. Diejenigen Schalttransistoren, die nebeneinander liegenden, an den gleichen Leseverstärker angeschlossenen Bitleitungen zugeordnet sind, werden durch ein gemeinsames Steuersignal CSL0, CSL1 bzw. CSL2 gesteuert. Insgesamt wird also bei einem Auslesevorgang in den Leseverstärker 20 die auszulesende Dateninformation einphasig (single-ended) eingespeist, aber als differentielles Datensignal ausgangsseitig bereitgestellt und differentiell an die Sammelleitungen übergeben.

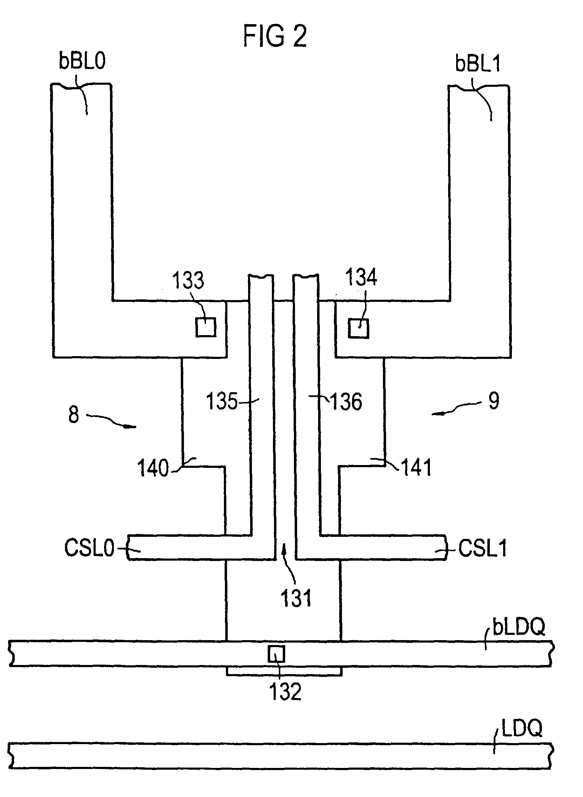

Die Daten von zwei unmittelbar nebeneinander benachbart angeordneten Datenleitungen des gleichen Typs (d.h. beide invertiert oder beide nichtinvertiert) werden auf die gleiche Sammelleitung bLDQ oder LDQ ausgegeben. Dies hat zur Folge, daß die jeweiligen von der Bitleitung abgewandten Dotierungsgebiete der zugeordneten Schalttransistoren an die gleiche Sammelleitung angeschlossen sind. Im Fall der beiden unmittelbar benachbarten bBL0, bBL1 weisen die Schalttransistoren 8, 9 einen gemeinsamen Anschluß 13 auf, der an die Sammelleitung bLDQ kontaktiert ist. Der Kontakt 13 wird vorzugsweise als einziger, gemeinsamer Kontakt ausgeführt. Dadurch ergeben sich Vereinfachungen im Layout. Vorteilhafter werden diese Dotierungsgebiete der Transistoren 8, 9 als gemeinsames Dotierungsgebiet ausgeführt (wie in Figur 2 im Detail dargestellt). Durch diese Vereinfachungen ergibt sich ein Flächengewinn in Richtung der Sammelleitungen bLDQ, LDQ.

Die entsprechenden Verhältnisse ergeben sich bei allen anderen benachbarten Bitleitungen gleichen Typs (d.h. beide invertiert oder beide nichtinvertiert). Beispielsweise sind die Bitleitungen BL1, BL2 über die Transistoren 10, 11, die einen gemeinsamen Kontakt aufweisen, an die Sammelleitung LDQ angeschlossen. Entsprechendes gilt für die jeweiligen die Transistoren 7, 12 enthaltenden Schalttransistorpaare.

Das in Figur 1 in der Umgebung der Transistoren 8, 9 durch die strichpunktierte Linie gekennzeichnete Gebiet ist in Figur 2 in Aufsicht auf das Layout detaillierter dargestellt. Entsprechende Elemente sind mit gleichen Bezugszeichen versehen. Die Transistoren 8, 9 weisen ein gemeinsames Dotierungsgebiet 131 auf. Das Dotierungsgebiet 131 ist über einen Kontakt 132 mit der invertierten Sammelleitung bLDQ verbunden. Über Kontakte 133, 134 sind die invertierten Bitleitungen bBL0, bBL1 an die anderen die Transistoren bildenden Dotierungsgebiete 140, 141 angeschlossen. Am Rand des gemeinsamen Dotierungsgebiets 131 verlaufen die jeweiligen Gateelektroden 135, 136 der beiden Transistoren 8, 9. Unterhalb der Gateelektroden bildet sich im Betrieb der Kanal des MOS-Transistors aus.

Der Abstand der Gateelektroden 135, 136 beträgt mindestens die Justierungsgenauigkeit des Herstellungsprozesses, also mindestens die Minimalgatelänge. Demgegenüber würden bei einer herkömmlichen Realisierung entsprechender Transistoren mittels getrennter Dotierungsgebiete die entsprechenden Gateelektroden einen Mindestabstand von der dreifachen Minimalgatelänge aufweisen, die erforderlich ist, für die jeweilgen getrennte Dotierungsgebiete und außerdem den Abstand dieser Dotierungsgebiete voneinander selbst. In Richtung der Sammelleitung ergibt sich daher ein Flächengewinn von mindesten der zweifachen Minimalgatelänge. Bei der Vielzahl der erforderlichen Transistorpaare in Halbleiterspeichern heute herstellbarer Kapazität ergibt sich eine merkbare Verringerung an Flächenbedarf für die Realisierung solcher Anschlußtransistoren, durch die die Bitleitungen an die Sammelleitungen kontaktiert werden. Wie üblich verlaufen die Bitleitungen BL0, bBL0, BL1, BL2, dBL2 in einer ersten Metallisierungsebene, während die Sammelleitungen bLDQ, LDQ in einer anderen, üblicherweise darüber liegenden zweiten Metallisierungsebene verlaufen. Überkreuzungen der Leitungen derselben Ebene verbieten sich daher.

Die Gateelektroden 135, 136 verlaufen in Figur 2 längs ihres für die Transistorfunktion wirksamen Abschnitts vertikal und parallel zur Richtung der Bitleitungen. Es ist vorteilhaft, den Verlauf der Gateelektroden geknickt in Richtung der Bitleitungen zu führen. D.h. der Verlauf der Gateelektroden über das gemeinsame Dotierungsgebiet umfaßt Komponenten sowohl in Richtung der Bitleitung als auch senkrecht dazu. Dadurch ist es möglich bei gleich bleibender, die Transistorfunktion (z.B. W/L-Verhältnis) den Transistor in Richtung der Bitleitung mit geringerer Tiefe, also schmäler, auszuführen. Dies erfordert zwar eine Ausdehnung der Dotierungsgebiete in Richtung senkrecht zur Bitleitung, d.h. entlang der Sammelleitung. In diese Richtung steht jedoch derjenige Platz, der durch den gemeinsamen Kontakt zur Sammelleitung bzw. weiterhin durch die gemeinsam ausgeführten Dotierungsgebiete gewonnen wurde, zur Verfügung. Dadurch können die Sammelleitungen bLDQ, LDQ näher am Speicherzellenfeld plaziert werden. Die Fläche des den Halbleiterspeicher enthaltenden Halbleiterchips wird dadurch verringert.

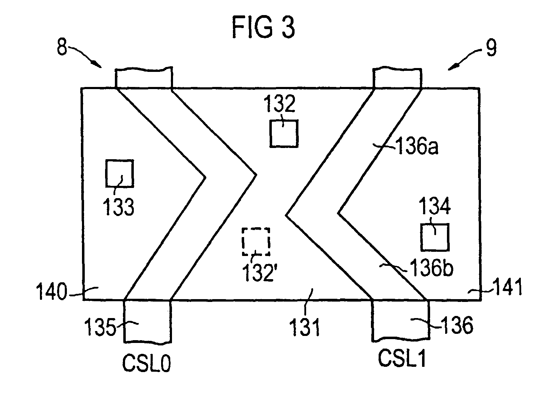

In Figur 3 ist das Layout für ein Beispiel für eine in Richtung der Bitleitungen geknickte Ausführung der Gateelektroden der Schalttransistoren 8, 9 gezeigt. Im Vergleich zur Figur 2 entsprechende Elemente sind mit gleichen Bezugszeichen versehen. Die Anordnung zeigt die Transistoren 8, 9 mit dem gemeinsamem Dotierungsgebiet 131. Das andere Dotierungsgebiet des Hauptstrompfads der Transistoren 8, 9 ist mit 140 bzw. 141 gekennzeichnet. An letztere Dotierungsgebiete sind die (nicht dargestellten) Bitleitungen über Kontakte 133, 134 angeschlossen. Der Kontakt 132 verbindet das gemeinsame Dotierungsgebiet 131 an die (nicht dargestellte) Sammelleitung bLDQ. Zur Platzersparnis ist der Kontakt 132 zwischen die Gateelektroden 135, 136 gelegt. Die Sammelleitungen verlaufen zweckmäßigerweise direkt oberhalb des Kontakts 132 in der zweiten Metallisierungsebene. Ein alternativer Anschluß an die andere Sammelleitung LDQ kann durch einen Kontakt an der Stelle 132' hergestellt werden. Die Sammelleitungen können auch außerhalb der von den Transistoren 8, 9 belegten Fläche verlaufen, wobei eine Verbindung vom Kontakt 132 bzw. 132' zur entsprechenden Sammelleitung durch eine weitere Metalleiterbahn in der ersten Verdrahtungsebene hergestellt wird.

Um für die Transistoren 8, 9 in Richtung der Bitleitungen eine geringere Tiefe zu erhalten, sind die Gateelektroden 135, 136 zwischen den Dotierungsgebieten 140, 131, 141 geknickt ausgeführt, wobei die jeweiligen geradlinigen Abschnitte, z.B. 136a, 136b, Richtungskomponenten sowohl in vertikaler als auch horizontale Richtungen haben. Prinzipiell denkbar ist auch, daß der Verlauf der streifenförmigen Gateelektroden mehrfach Richtungsänderungen und Knicke aufweist.

## Patentansprüche

1. Halbleiterspeicher, umfassend:
- eine Vielzahl von nebeneinander angeordneten und die aus Speicherzellen (1, ..., 6) auszulesende Information führenden invertierten Bitleitungen (bBL0, bBL1, bBL2), die mit solchen der Speicherzellen (4, 2, 6) verbunden sind, die die zu speichernde Information invertiert speichern, und nichtinvertierten Bitleitungen (BL0, BL1, BL2), die mit solchen der Speicherzellen (1, 5, 3) verbunden sind, die die zu speichernde Information nicht invertiert speichern, wobei je zwei invertierte Bitleitungen (bBL0, bBL1) oder je zwei nichtinvertierte Bitleitungen (BL1, BL2) ohne eine dazwischenliegende weitere Bitleitung benachbart angeordnet sind, und
- je einen einer Bitleitung zugeordneten Schalttransistor (7, ..., 12) und eine invertierte und eine nichtinvertierte Sammelleitung (bLDQ, LDQ), wobei über den Schalttransistor die zugeordnete Bitleitung mit einer der Sammelleitungen verbindbar ist und alle invertierten Bitleitungen (bBL0, bBL1, bBL2) mit der invertierten Sammelleitung (bLDQ) und alle nichtinvertierten Bitleitungen (BL0, BL1, BL2) mit der nichtinvertierten Sammelleitung (LDQ) verbindbar sind.

2. Halbleiterspeicher nach Anspruch 1,
**dadurch gekennzeichnet,** daß diejenigen Schalttransistoren (8, 9; 10, 11), die zwei benachbarten Bitleitungen zugeordnet sind, ein gemeinsames Dotierungsgebiet (131) aufweisen.

3. Halbleiterspeicher nach Anspruch 2,
**dadurch gekennzeichnet,** daß das gemeinsame Dotierungsgebiet (131) an eine der Sammelleitungen (bBDQ) kontaktiert ist.

4. Halbleiterspeicher nach Anspruch 2 oder 3,
**dadurch gekennzeichnet,** daß
am gemeinsamen Dotierungsgebiet (131) randseitig je eine Gatelektrode (135, 136) angeordnet ist, an die ein die Schaltfunktion des jeweiligen Transistors steuerndes Schaltsignal (CSL0, CSL1) anzulegen ist.

5. Halbleitspeicher nach Anspruch 4,
**gekennzeichnet durch**
einen geknickten Verlauf der Gateelektroden (131) längs des Dotierungsgebiets.

6. Halbleiterspeicher nach einem der Ansprüche 1 bis 5,
**dadurch gekennzeichnet,** daß
je eine invertierte Bitleitung (bBL0) und eine benachbart angeordnete nichtinvertierte Bitleitung (BL0) an die Eingangs- und Ausgangsanschlüsse eines einen Differenzverstärker umfassenden Leseverstärkers (20) geschaltet ist.

7. Halbleiterspeicher nach einem der Ansprüche 1 bis 6,
**dadurch gekennzeichnet,** daß
benachbart zu einer invertierten Bitleitung (bBL0) eine weitere invertierte Bitleitung (bBL1), benachbart zu dieser invertierten Bitleitung (bBL1) eine nichtinvertierte Bitleitung (BL1) und benachbart zu dieser nichtinvertierten Bitleitung (BL1) eine weitere nichtinvertierte Bitleitung (BL2) jeweils ohne dazwischenliegende weitere Bitleitungen angeordnet sind.

8. Halbleiterspeicher nach einem der Ansprüche 1 bis 7,
**dadurch gekennzeichnet,** daß
die Bitleitungen (bBL0, bBL1, bBL2, BL0, BL1, BL2) in einer ersten Metallisierungsebene verlaufen und die Sammelleitungen (bLDQ, LDQ) in einer anderen zweiten Metallisierungsebene verlaufen.
